# EUROPEAN PATENT APPLICATION

(11) **EP 4 175 429 A1**
(43) Date of publication of application: **03.05.2023**
(21) Application number: 21847426.0
(22) Date of filing: 10.07.2021
(51) Int. Cl.: H05K 7/14

(54) **HALF-WIDTH NODE AND ELECTRONIC DEVICE**

(30) Priority: 23.07.2020 CN 202010717451
(71) Applicant: Huawei Technologies Co., Ltd., Longgang District, Shenzhen, Guangdong 518129 (CN)
(72) Inventor: LI, Min, Shenzhen, Guangdong 518129 (CN); NIU, Yuanjun, Shenzhen, Guangdong 518129 (CN); LI, An, Shenzhen, Guangdong 518129 (CN); ZHOU, Haihao, Shenzhen, Guangdong 518129 (CN); LIU, Zhiquan, Shenzhen, Guangdong 518129 (CN)
(74) Representative: Thun, Clemens
(86) International application number: PCT/CN2021/105630
(87) International publication number: WO 2022/017206

(57) **Abstract**

This application provides a half-width node and an electronic device. The electronic device includes two juxtaposed slots, and the half-width node is installed in the slot. The half-width node includes a first part and a second part. The first part and the second part penetrate the half-width node along a first direction, are juxtaposed in the two slots along a third direction, and are respectively a first half-width node and a second half-width node. A height of the first part along a second direction is less than a height of the second part along the second direction, so that a first part of the first half-width node and a first part of the second half-width node can partially overlap along the second direction. The first direction is an insertion direction when the half-width node is used, the second direction is a direction perpendicular to a surface of a circuit board, and the third direction is perpendicular to the first direction and the second direction. In this solution, a width of the half-width node along the third direction can be designed to be large, to increase a quantity of electronic components that can be accommodated and disposed in the half-width node, so as to improve integration of the electronic device.

## Description

### TECHNICAL FIELD

This application relates to the field of electronic device technologies, and in particular, to a half-width node and an electronic device.

### BACKGROUND

A server is a common electronic device, and generally includes a framework and a node disposed in the framework. When the server has many functions, many nodes are usually disposed. Therefore, many servers each include a framework and a plurality of pluggable nodes installed in the framework. The plurality of nodes are interconnected through a backplane in terms of power supply and a signal, and then a heat dissipation assembly is used to dissipate heat for the plurality of nodes.

The nodes are classified into full-width nodes and half-width nodes based on different installation forms or sizes. The full-width node means that a width of the node is approximately the same as a width of the framework of the server, and only one full-width node can be installed at each layer of the server. The half-width node means that a width of the node is approximately the same as half of a width of the framework of the server, and two half-width nodes may be installed at each layer of the server.

The half-width node is more flexible than the full-width node. Therefore, the half-width node is a common node form in current server setting. However, in a current server with a half-width node, when a size of the framework is fixed, a width of a circuit board when the half-width node is used is less than half of a width of a circuit board when the full-width node is used. In other words, when the size of the framework is fixed, a capability of two half-width nodes that can accommodate and dispose an electronic component is weaker than a capability of one full-width node that can accommodate and dispose an electronic component. Therefore, when the half-width node is used, integration of the server is greatly reduced. This also becomes a bottleneck in use of the half-width node.

### SUMMARY

This application provides a half-width node and an electronic device, to increase a total size of nodes installed in the electronic device and improve integration of the electronic device.

According to a first aspect, this application provides a half-width node. The half-width node includes a front panel and a circuit board. The circuit board is fastened to the front panel, and the front panel and the circuit board are arranged along a first direction, so that the half-width node is installed on a framework of an electronic device. The half-width node includes a first part and a second part, which may be specifically as follows: The first part includes one part of the front panel and one part of the circuit board, and the second part includes another part of the front panel and another part of the circuit board. The first part and the second part penetrate the half-width node along the first direction, and a height of the first part along a second direction is less than a height of the second part along the second direction. The first direction is an insertion direction when the half-width node is used, and the second direction is a direction perpendicular to a surface of the circuit board. When the half-width node is installed, first parts of adjacent half-width nodes may partially overlap, so that a width of the half-width node along a third direction may be designed to be relatively large. The third direction is perpendicular to the first direction and the second direction. This helps increase a quantity of electronic components that can be accommodated and disposed in the half-width node, and improve a hardware capability of the half-width node, thereby improving integration of the electronic device.

When the half-width node is specifically designed, the height of the first part of the half-width node along the second direction may be less than half of the height of the second part of the half-width node along the second direction. When the half-width node is installed, the first part also needs to have a support structure. Therefore, along the second direction, the support structure occupies a specific height. The height of the first part along the second direction is designed to be less than half of the height of the second part along the second direction, so that the first part may be installed on the support structure. In this way, after the first parts of the two half-width nodes are installed in an overlapping manner, a height of regions in which the first parts of the two half-width nodes are located is not greater than a height of regions in which the second parts of the two half-width nodes are located. Therefore, during installation, each row of half-width nodes can use the height of the second part along the second direction as a reference, to improve integration of the electronic device along the second direction.

Heights of the electronic components disposed on the circuit board are different. During specific disposing, the electronic components having a relatively high height along the second direction are disposed in a second region, and the electronic components having a relatively low height along the second direction are disposed in a first region, so that the first regions of the two adjacent half-width nodes can overlap.

In a possible implementation, a width W 1 of the first part of the half-width node along the third direction and a width W of the half-width node along the third direction meet that 5%·W≤W1≤20%·W. Therefore, the two adjacent half-width nodes may have a specific overlapping region. In addition, the second part of the half-width node may also have a size sufficient to dispose a relatively high electronic component.

According to a second aspect, this application further provides an electronic device, where the electronic device includes a framework and the half-width node in any one of the foregoing technical solutions. The framework includes at least one row of slots, each row of slots includes two juxtaposed slots, and the half-width node is installed in the slot. For ease of description, the half-width nodes installed in the two juxtaposed slots are respectively defined as a first half-width node and a second half-width node. Along a second direction, the first part of the first half-width node and the first part of the second half-width node overlap along a second direction. Therefore, a sum of widths of the first half-width node and the second half-width node in the two juxtaposed slots along the third direction is greater than a width of the full-width node installed under equivalent conditions. This helps increase a quantity of electronic components that can be accommodated and disposed in the half-width node, and improve integration of the electronic device.

To install the half-width node, an S-shaped bracket is further fastened to the framework, and the S-shaped bracket is located between the two juxtaposed slots, so that the first part of the half-width node can be installed on the S-shaped bracket. The S-shaped bracket may have an installation slot, and along the second direction, every two installation slots are corresponding to one slot. Orientations of two adjacent installation slots are opposite, to respectively install the first half-width node and the second half-width node. The S-shaped bracket can implement a structure in which the first parts of the first half-width node and the second half-width node are installed in an overlapping manner. This also helps improve stability of installation of the half-width node.

The S-shaped bracket includes a clamping slot that is in a one-to-one correspondence with a slot. The front panel of the half-width node has an ejector lever, and the ejector lever can be clamped into the clamping slot, to lock the half-width node in the slot of the framework.

A guide rail for installing the half-width node is further disposed in the installation slot of the S-shaped bracket, and the first part of the half-width node has a sliding structure adapted to the guide rail, so that the half-width node is assembled into the S-shaped bracket through sliding.

When the S-shaped bracket is specifically disposed, the S-shaped bracket may be one structure integrated with the framework, that is, the framework with the S-shaped bracket is directly prepared. Alternatively, the S-shaped bracket may be detachably installed in the framework, for example, the S-shaped bracket is installed in the framework by using a screw. In this solution, the S-shaped bracket may be first prepared, and then the S-shaped bracket is installed in the framework after a structure such as a guide rail that needs to be installed in the S-shaped bracket is installed, thereby facilitating maintenance of the S-shaped bracket. Alternatively, the S-shaped bracket may be welded to the framework, or the S-shaped bracket may be first prepared, and then the S-shaped bracket is installed in the framework.

A plurality of electronic components are disposed on the foregoing circuit board. When the first half-width node and the second half-width node are installed along the second direction, an orientation of a side that is of the first half-width node and that has the electronic component may be opposite to an orientation of a side that is of the second half-width node and that has the electronic component. Specifically, the side that is of the first half-width node and that has the electronic component is enabled to face the first part of the second half-width node, and the side that is of the second half-width node and that has the electronic component is enabled to face the first part of the first half-width node. To be specific, the first half-width node and the second half-width node are inserted in opposite directions, to fully use space of a slot along the second direction, and improve integration of the electronic device.

Structures of the first half-width node and the second half-width node may be the same. This means that specifications of the first half-width node and the second half-width node may be the same. However, specific electronic components included in the half-width nodes may be the same or different, and may be designed according to an actual product requirement. In this solution, the half-width nodes with a same specification may be prepared, thereby helping simplify a manufacturing process of the half-width node.

A type of the electronic device in embodiments of this application is not specifically limited. The electronic device may be a computing device, a network device, or a storage device, and all the devices are applicable to the technical solutions in embodiments of this application.

### BRIEF DESCRIPTION OF DRAWINGS

FIG. 1 is a schematic diagram of a structure of an electronic device according to the conventional technology;
FIG. 2 is a schematic diagram of a structure of an electronic device according to an embodiment of this application;
FIG. 3 is a schematic diagram of a top-view structure of a half-width node according to an embodiment of this application;
FIG. 4 is a schematic diagram of a cross-sectional structure of a half-width node according to an embodiment of this application;
FIG. 5 is a schematic diagram of an installation structure of a half-width node according to an embodiment of this application;
FIG. 6 is a schematic diagram of a structure of a framework according to an embodiment of this application;
FIG. 7 is a schematic diagram of a structure of cooperation between a half-width node and an S-shaped bracket according to an embodiment of this application; and
FIG. 8 is a schematic diagram of an installation structure of a half-width node according to an embodiment of this application.

### Reference numerals:

1-Framework; 11-Rectangular bracket;
12-Slot; 13-S-shaped bracket;
131-Installation slot; 132-Clamping slot;
2-Half-width node; 21-Front panel;
211-Ejector lever; 22-Circuit board;
23-Electronic component; 24-First part;
25-Second part; 26-First half-width node;
27-Second half-width node; and 3-Full-width node.

### DESCRIPTION OF EMBODIMENTS

To make the objectives, technical solutions, and advantages of this application clearer, the following further describes this application in detail with reference to the accompanying drawings.

For ease of understanding a half-width node and an electronic device provided in embodiments of this application, the following first describes application scenarios of the half-width node and the electronic device.

The half-width node provided in embodiments of this application may be applied to any electronic device that requires the half-width node. The electronic device may be specifically a computing device (such as a server), a network device (such as a switch), a storage device (such as a storage array), or the like. The electronic device may include a framework and the half-width node disposed in the framework, and two half-width nodes may be installed in each row in the framework. The half-width node includes a circuit board, and a plurality of electronic components are disposed on the circuit board. Half-width nodes are electrically connected through a backplane, to implement a function of the electronic device. A hardware capability of the half-width node directly affects integration of the electronic device. However, as functions of the electronic device become richer, improvement of integration is currently a relatively important objective of the electronic device.

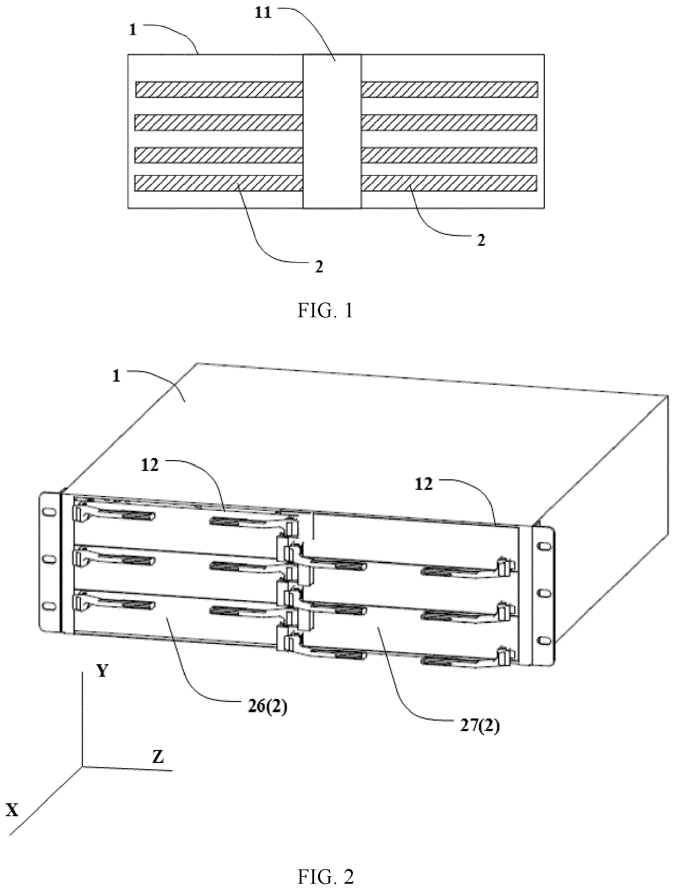

FIG. 1 is a schematic diagram of a structure of an electronic device according to the conventional technology. As shown in the figure, the electronic device according to the conventional technology includes a framework 1 and a half-width node 2. To install the half-width node 2, a middle part of the framework 1 includes a rectangular bracket 11, and the half-width node 2 is installed between the rectangular bracket 11 and the framework 1. In the conventional technology, the rectangular bracket 11 occupies specific space in a width direction of the framework 1. Therefore, a size of the half-width node 2 is designed to be relatively small. When a size of the framework 1 is fixed, widths of two half-width nodes 2 are far less than a width of one full-width node. Therefore, in the conventional technology, a size of each half-width node 2 is relatively small, and a quantity of electronic components 23 that can be accommodated and disposed is also small. In this way, a hardware capability is relatively poor, and integration of the electronic device is relatively high. In view of this, this application provides the half-width node and the electronic device, to increase a size of the half-width node 2, increase a quantity of electronic components 23 that can be accommodated and disposed in the half-width node 2, and improve integration of the electronic device.

Terms used in the following embodiments are merely intended to describe specific embodiments, but are not intended to limit this application. The terms "one", "a", "the", "the foregoing", "this", and "the one" of singular forms used in this specification and the appended claims of this application are also intended to include expressions such as "one or more", unless otherwise specified in the context clearly.

Reference to "one embodiment", "a specific embodiment", or the like described in this specification means that a specific feature, structure, or characteristic described with reference to the embodiment is included in one or more embodiments of this application. The terms "include", "have", and their variants all mean "include but are not limited to", unless otherwise specifically emphasized in another manner.

FIG. 2 is a schematic diagram of a structure of an electronic device according to an embodiment of this application. Referring to FIG. 2, the electronic device in this embodiment of this application includes a framework 1 and a half-width node 2 installed in the framework 1, where the framework 1 includes at least one row of slots 12, each row of slots 12 includes two slots 12, and the half-width node 2 is installed in the slot 12.

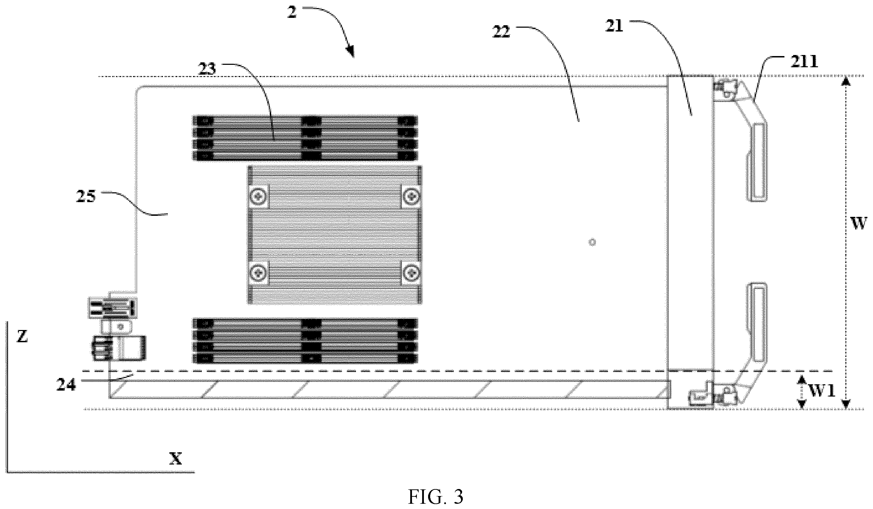

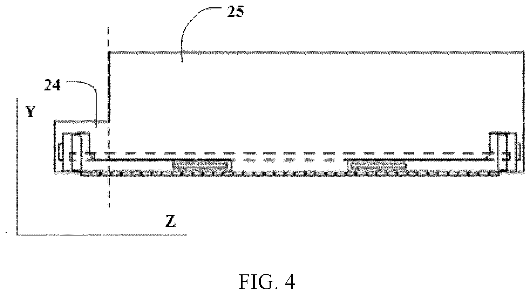

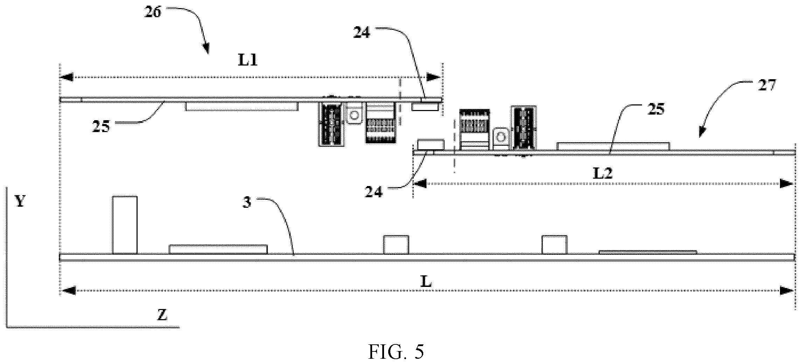

FIG. 3 is a schematic diagram of a top-view structure of a half-width node according to an embodiment of this application. FIG. 4 is a schematic diagram of a cross-sectional structure of a half-width node according to an embodiment of this application. FIG. 5 is a schematic diagram of an installation structure of a half-width node according to an embodiment of this application. With reference to FIG. 3, FIG. 4, and FIG. 5, the half-width node 2 in this embodiment of this application includes a front panel 21, and a circuit board 22 fastened to the front panel 21. Electronic components 23 are disposed on the circuit board 22, for example, structures such as a central processing unit CPU, a memory module, and a hard disk, so as to implement a function of the electronic device. When the half-width node 2 is installed in the framework 1, the circuit board 22 is inserted into the slot 12 of the framework 1. An insertion direction of the half-width node 2 is a first direction X, and a direction perpendicular to a surface of the circuit board 22 is a second direction Y. The half-width node 2 includes a first part 24 and a second part 25. The first part 24 and the second part 25 penetrate the half-width node 2 along the first direction X, and a height of the first part 24 along the second direction Y is less than a height of the second part 25 along the second direction Y. In the figure, a dashed line is used as a schematic line for distinguishing the first part 24 from the second part 25. In an actual product, a definite separation line does not necessarily exist, and the first part 24 and the second part 25 are distinguished only based on a height along the second direction Y. As shown in the figure, the front panel 21 includes both a part located in the first part 24 and a part located in the second part 25. The circuit board 22 includes both a part located in the first part 24 and a part located in the second part 25. In other words, the first part 24 includes one part of the front panel 21, and further includes one part of the circuit board 22. The second part 25 includes another part of the front panel, and further includes another part of the circuit board 22. When the half-width node 2 is installed in the framework 1 of the electronic device, one half-width node 2 may be installed in each slot 12, and two half-width nodes 2 are installed in each row of slots 12 of the framework 1. For ease of description, the half-width nodes 2 in the two juxtaposed slots 12 are respectively a first half-width node 26 and a second half-width node 27. The first part 24 of the first half-width node 26 faces the second half-width node 27, the first part 24 of the second half-width node 27 faces the first half-width node 26, and the first part 24 of the first half-width node 26 and the first part 24 of the second half-width node 27 at least partially overlap along the second direction Y.

In this solution, the height of the first part 24 of the half-width node 2 along the second direction Y is less than the height of the second part 25 of the half-width node 2 along the second direction Y. Therefore, when the half-width nodes 2 are installed in the juxtaposed slots 12, the first parts 24 of the two juxtaposed half-width nodes 2 may at least partially overlap. Referring to FIG. 5, it is defined as follows: A third direction Z is perpendicular to the first direction X and the second direction Y, that is, the third direction Z is a width direction of the half-width node 2. In this case, the first half-width node 26 and the second half-width node 27 may share a section of a region in the third direction Z, and a sum of widths that are along the third direction Z and that are of the first half-width node 26 and the second half-width node 27 that are juxtaposed may be greater than a width of a full-width node 3 that can be installed in the framework 1. As shown in the figure, a width of the first half-width node 26 along the third direction Z is L1, and a width of the second half-width node 27 along the third direction Z is L2. Under equivalent conditions, if a width of the installable full-width node 3 along the third direction Z is L, L1+L2>L. Therefore, compared with the conventional technology, in this solution, the electronic device uses a structure of the half-width node 2. When a size of the framework 1 remains unchanged, a sum of widths of the two half-width nodes 2 is not less than a width of the full-width node 3, but is greater than the width of the full-width node 3. Therefore, in this solution, a quantity of electronic components 23 that can be accommodated and disposed in the half-width node 2 is relatively large, and a hardware capability is relatively strong. This helps improve integration of the electronic device.

Specifically, when the electronic component 23 is disposed on the circuit board 22 of the half-width node 2, because heights of the electronic components 23 along the second direction Y are different, the electronic component 23 whose height is relatively high along the second direction Y may be selected to be disposed on the second part 25, and the electronic component 23 whose height is relatively low along the second direction Y is disposed on the first part 24. In other words, in the half-width node 2, a height of the electronic component 23 on the first part 24 along the second direction Y is less than a height of the electronic component 23 on the second part 25 along the second direction Y. After the components are arranged based on a height, operation of the components is not affected. Specifically, the electronic component 23 can be electrically connected based on a function through wiring of the circuit board 22, so that the height of the first part 24 along the second direction Y is less than the height of the second part 25 along the second direction Y.

It should be noted that, in this embodiment of this application, it is not required that heights of all the electronic components 23 on the first parts 24 along the second direction Y are less than heights of all the electronic components 23 on the second parts 25 along the second direction Y. For ease of description, "a height along the second direction Y" is hereinafter referred to as "a height". This embodiment of this application only needs to ensure that a height of the highest electronic component 23 on the first part 24 is less than a height of the highest electronic component 23 on the second part 25, and also allows heights of several electronic components 23 on the second part 25 to be less than heights of several electronic components 23 on the first part 24.

When the half-width node 2 is specifically designed, the height of the first part 24 along the second direction Y may be less than half of the height of the second part 25 along the second direction Y. When the half-width node 2 is installed, a side corresponding to the first part 24 needs to have a structure that supports the half-width node 2, for example, an S-shaped bracket 13. Therefore, the framework 1 needs to occupy specific space in the second direction Y. In this solution, to improve integration of the electronic device, after the half-width node 2 is installed, a sum of heights occupied by the first parts 24 of the first half-width node 26 and the second half-width node 27 along the second direction Y may be not greater than a height of the second part 25 of the half-width node 2 along the second direction Y. In this solution, along the second direction Y, a size of the slot 12 is designed by using a height of the second part 25 as a reference, and then each half-width node 2 is installed, so that density of installation of the half-width node 2 can be improved, and integration of the electronic device can be improved.

Still referring to FIG. 3, when the half-width node 2 is specifically disposed, a width W1 of the first part 24 of the half-width node 2 along the third direction Z and a width W of the half-width node 2 along the third direction Z may meet that 5%·W≤W1≤20%·W. The width of the first part 24 of the half-width node 2 along the third direction Z occupies 5%-20% of a total width of the half-width node 2, and a proportion may be specifically 6%, 7%, 8%, 10%, 12%, 15%, 17%, 18%, 19%, or the like. The proportion is not specifically limited, provided that two adjacent half-width nodes 2 can have a relatively large overlapping region. In addition, an area of the second part 25 is sufficient to dispose a relatively high electronic component, to meet a function of the electronic device.

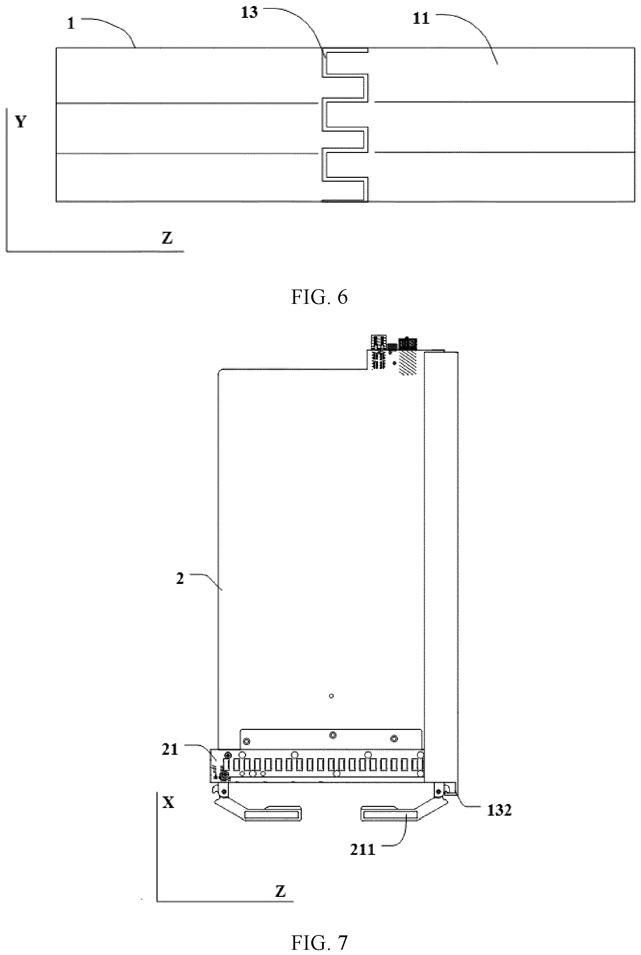

FIG. 6 is a schematic diagram of a structure of a framework according to an embodiment of this application. Referring to FIG. 6, in an embodiment, an S-shaped bracket 13 is disposed in a middle part of the framework 1 along the third direction Z, and the S-shaped bracket 13 is located between two juxtaposed slots 12, and is configured to install the first part 24 of the half-width node 2. The slot 12 is formed between the S-shaped bracket 13 and a side wall of the edge of the framework 1, the first part 24 of the half-width node 2 is installed in the S-shaped bracket 13, and the second part 25 is installed on the side wall of the edge of the framework 1. Each row of slots 12 corresponding to the S-shaped bracket 13 has two installation slots 131, and the two installation slots 131 respectively face the slots 12 on both sides. The installation slot 131 is adapted to the first part 24, and the first part 24 extends into the installation slot 131. In this solution, the first parts 24 of the two juxtaposed half-width nodes 2 are installed in an overlapping manner by using the S-shaped bracket 13, and reliability is relatively high.

In a specific embodiment, a width of the installation slot 131 along the third direction Z is not greater than a width of the first part 24 of the half-width node 2 along the third direction Z, so that the first part 24 may be installed at a bottom of the installation slot 131 along the third direction Z. Specifically, a difference between the width of the installation slot 131 along the third direction Z and the width of the first part 24 of the half-width node 2 along the third direction Z may be not greater than 5 mm. Therefore, a structure of the electronic device can be relatively compact, so that the first parts 24 of adjacent half-width nodes 2 overlap as much as possible, to improve integration of the electronic device.

To install the half-width node 2, a guide rail adapted to the half-width node 2 through sliding is further disposed in the installation slot 131 of the S-shaped bracket 13. Correspondingly, the half-width node 2 also has a sliding structure adapted to the guide rail. The side wall of the edge of the framework 1 may also have a guide rail. In this case, both sides of the half-width node 2 are installed in the slot 12 by using the sliding structure, to facilitate installation and maintenance of the half-width node 2.

FIG. 7 is a schematic diagram of a structure of cooperation between a half-width node and an S-shaped bracket according to an embodiment of this application. As shown in the figure, the front panel 21 of the half-width node 2 has an ejector lever 211, and each slot 12 corresponding to the S-shaped bracket 13 has a clamping slot 132. When the half-width node 2 is installed in the slot 12, the ejector lever 211 is clamped into the clamping slot 132 of the S-shaped bracket 13, to fasten the half-width node 2 to the framework 1, thereby improving reliability of installing the half-width node 2.

A manner of a connection between the S-shaped bracket 13 and the framework 1 is not specifically limited. In an optional embodiment, the S-shaped bracket 13 and the framework 1 may be an integrally molded structure, to directly prepare the framework 1 and the S-shaped bracket 13.

In another optional embodiment, the S-shaped bracket 13 may be installed in the framework 1 by using a screw. In this solution, the S-shaped bracket 13 may include a sheet metal support member, and a structure such as the guide rail is installed on the sheet metal support member of the S-shaped bracket 13. In this way, the S-shaped bracket 13 is first prepared, and then the S-shaped bracket 13 is installed on the framework 1 by using a screw. Not only preparation processes of the framework 1 and the S-shaped bracket 13 may be simplified, but also detachable installation of the S-shaped bracket 13 may be implemented. When the S-shaped bracket 13 needs to be maintained, the S-shaped bracket 13 may be detached and then repaired or replaced for ease of maintenance operation.

In still another embodiment, the S-shaped bracket 13 may be alternatively welded to the framework 1, or the S-shaped bracket 13 may include a sheet metal support member, and a structure such as the guide rail is installed on the sheet metal support member of the S-shaped bracket 13. In this way, the S-shaped bracket 13 is first prepared, and then the S-shaped bracket 13 is welded to the framework 1. This solution also helps simplify the preparation processes of the framework 1 and the S-shaped bracket 13.

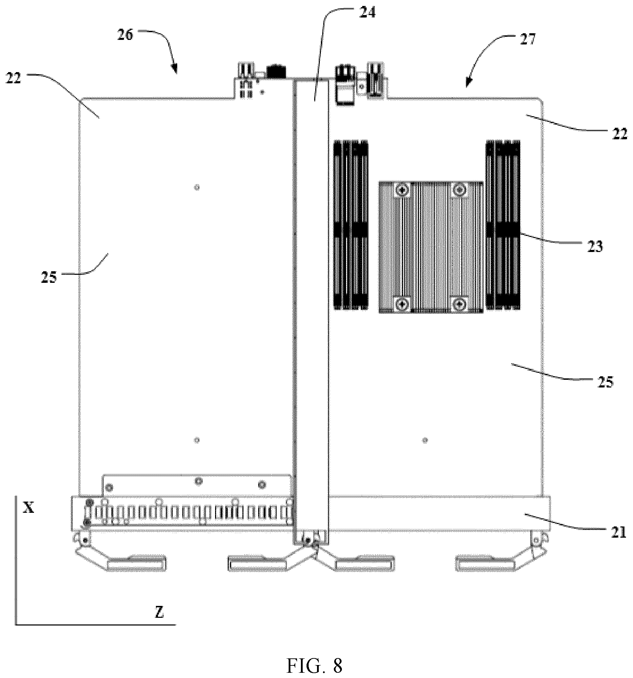

FIG. 8 is a schematic diagram of an installation structure of a half-width node according to an embodiment of this application. With reference to FIG. 8 and FIG. 5, a plurality of electronic components 23 are disposed on the circuit board 22 of the half-width node 2. In the two juxtaposed half-width nodes 2, along the second direction Y, an orientation of a side that is of the first half-width node 26 and that has the electronic component 23 is opposite to an orientation of a side that is of the second half-width node 27 and that has the electronic component 23. In other words, the first half-width node 26 and the second half-width node 27 are inserted in opposite directions. As shown in the figure, when the two juxtaposed half-width nodes 2 are inserted in opposite directions, the side that is of the first half-width node 26 and that has the electronic component 23 faces a direction of the first part 24 of the second half-width node 27, and the side that is of the second half-width node 27 and that has the electronic component 23 faces a direction of the first part 24 of the first half-width node 26. In this solution, height space of the slot 12 of the framework 1 along the second direction Y can be fully used, to improve integration of the electronic device.

Still referring to FIG. 2 and FIG. 5, with reference to FIG. 8, the foregoing structures of the first half-width node 26 and the second half-width node 27 may be the same. Specifically, specifications of the first half-width node 26 and the second half-width node 27 are the same. Overall structures and shapes of the first half-width node 26 and the second half-width node 27 are the same. However, specific electronic components 23 disposed on the half-width node may be the same, or specific electronic components 23 disposed on the half-width node may be different to some extent, to implement different functions. The first half-width node 26 and the second half-width node 27 in this solution may be installed in any one of the two juxtaposed slots 12. The following uses the first half-width node 26 as an example with reference to a direction shown in the figure for description. The first half-width node 26 may be installed in the slot 12 on the left, and in this case, the electronic component 23 in the first half-width node 26 is located below the circuit board 22 along the second direction Y. After the first half-width node 26 is removed from the slot 12 on the left, the first half-width node 26 may be installed in the slot 12 on the right. In this case, the first half-width node 26 needs to be flipped, so that the electronic component 23 in the first half-width node 26 is located above the circuit board 22 along the second direction Y. In this case, the first half-width node 26 becomes the second half-width node 27 shown in the figure. Therefore, structures of the first half-width node 26 and the second half-width node 27 may be the same. In this solution, in a process of preparing the half-width node 2, half-width nodes 2 with a same specification may be prepared without a need to distinguish the half-width nodes 2 installed in the left slot 12 from the half-width nodes 2 installed in the right slot 12. This helps simplify a preparation process of the half-width node.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A half-width node, comprising a front panel and a circuit board fastened to the front panel, wherein the front panel and the circuit board are arranged along a first direction;
the half-width node comprises a first part and a second part, the first part and the second part separately penetrate the half-width node along the first direction, the first part comprises one part of the circuit board, the second part comprises another part of the circuit board, and a height of the first part along a second direction is less than a height of the second part along the second direction; and
the first direction is an insertion direction when the half-width node is used, and the second direction is a direction perpendicular to a surface of the circuit board.

2. The half-width node according to claim 1, wherein the height of the first part along the second direction is less than half of the height of the second part along the second direction.

3. The half-width node according to claim 1 or 2, wherein a plurality of electronic components are disposed on the circuit board, and a height of the electronic component of the first part in the second direction is less than a height of the electronic component of the second part in the second direction.

4. The half-width node according to claim 1 or 2, wherein a width W 1 of the first part along a third direction and a width W of the half-width node along the third direction meet that 5%·W≤W1≤20%·W; and
the third direction is perpendicular to the first direction and the second direction.

5. An electronic device, comprising a framework and at least two half-width nodes according to any one of claims 1 to 4, wherein
the framework comprises at least one row of slots, each row of slots comprises two juxtaposed slots, the half-width node is installed in the slot, half-width nodes located in the two juxtaposed slots are respectively a first half-width node and a second half-width node, and along a second direction, a first part of the first half-width node and a first part of the second half-width node at least partially overlap.

6. The electronic device according to claim 5, wherein an S-shaped bracket is fastened to the framework, the S-shaped bracket is located between the two juxtaposed slots, and the first part of the half-width node is installed on the S-shaped bracket.

7. The electronic device according to claim 6, wherein the S-shaped bracket comprises a clamping slot that is in a one-to-one correspondence with the slot, a front panel of the half-width node comprises an ejector lever, and the ejector lever is clamped to the clamping slot.

8. The electronic device according to claim 6, wherein a guide rail slidably adapted to the half-width node is disposed on the S-shaped bracket, and the first part is slidably installed on the guide rail.

9. The electronic device according to claim 6, wherein the framework and the S-shaped bracket are of an integrated structure.

10. The electronic device according to claim 6, wherein the S-shaped bracket is installed in the framework by using a screw, or the S-shaped bracket is welded to the framework.

11. The electronic device according to claim 5, wherein a plurality of electronic components are disposed on a circuit board, and along the second direction, a side that is of the first half-width node and that has the electronic component faces the first part of the second half-width node, and a side that is of the second half-width node and that has the electronic component faces the first part of the first half-width node.

12. The electronic device according to claim 5, wherein the first half-width node and the second half-width node have a same structure.

13. The electronic device according to any one of claims 5 to 12, wherein the electronic device comprises a computing device, a network device, and a storage device.
